# EUROPEAN PATENT SPECIFICATION

(11) **EP 0 851 298 B1**
(45) Date of publication and mention of the grant of the patent: **16.06.2004**
(21) Application number: 97122389.6
(22) Date of filing: 18.12.1997
(51) Int. Cl.: G03F 7/004

(54) **Use of a solvent mixture for roller coating a radiation sensitive composition**
Verwendung eines Lösungsmittelgemisches zur Walzenbeschichtung einer strahlungsempfindlichen Zusammensetzung
Utilisation d'un mélange de solvants pour le couchage au rouleau d'une composition sensible aux radiations

(30) Priority: 26.12.1996 JP 34757896
(43) Date of publication of application: 01.07.1998
(73) Proprietor: Clariant Finance (BVI) Limited, Road Town, Tortola (VG)
(72) Inventor: Susukida, Kenji, Ogasa-gun, Shizuoka (JP)
(74) Representative: Hütter, Klaus, Dr.

(56) References cited:
- EP-A- 0 536 086
- EP-A- 0 558 272
- DE-A- 3 705 342
- GB-A- 1 324 548
- DATABASE WPI Section Ch, Week 8735 Derwent Publications Ltd., London, GB; Class A89, AN 87-246639 XP002057108 & JP 62 169 163 A (FUJI PHOTO FILM CO LTD) , 25 July 1987

## Description

### Background of the Invention

This invention relates to the use of a solvent mixture for coating a radiation sensitive composition by roller coating which can provide a resist layer with scarcely forming uneven coating when coated by roller coating method.

In manufacturing semiconductor integrated circuit elements, color filters, liquid crystal display elements, etc., lithographic technique has conventionally been employed for conducting fine work. In recent years, techniques enabling fine work on the order of sub-micron or sub-quarter micron have been investigated. In such lithographic technique, a positive- or negative-working radiation sensitive composition is coated on a substrate directly or after forming thereon an anti-reflective coating if necessary, and the coated composition is prebaked to form a radiation sensitive resist layer. Then, this radiation sensitive resist layer is pattern-wise exposed by various radiations such as ultraviolet rays, deep ultraviolet rays, electron beams, X-rays or the like, and developed to form a resist pattern. As the method for coating the radiation sensitive composition, there have conventionally been known various methods such as spin coating method, roller coating method, cast coating method, doctor coating method, dip coating method, etc. In manufacturing semiconductor integrated circuits, for example, a positive-working radiation sensitive composition is employed as a resist material and, as a coating method, spin coating method is often employed. On the other hand, in manufacturing liquid crystal display, too, a positive-working radiation sensitive composition is often employed and, as a coating method, roller coating method is employed as well as spin coating method. By the way, in the spin coating method, a resist solution dropped onto a substrate is cast in the peripheral direction of the substrate by the centrifugal force produced by the rotation of the substrate, with most of the resist solution being removed out of the periphery. The thus-removed resist solution is discarded.

Such spin coating method is e.g. disclosed in EP-A- 0 558 272 using a mixture of PGMEA and PG with a content of 2.5 % by weight of PG.

Thus, while this spin coating method enables one to form a resist layer of uniform thickness with ease, it has the defect that the amount of discarded resist solution is so large that it imposes high cost. On the other hand, roller coating method, which can utilize most of the resin used as a resist layer, serves to reduce manufacture cost, but has the defect that there arises uneven coating such as streaks and orange peel. For example, liquid crystal display elements manufactured using a resist layer having the coating defect of streaks provide non-uniform light areas, thus having no commercial values. Therefore, there has been required a radiation sensitive composition which does not cause uneven coating streaks.

### Summary of the Invention

It is an object of the present invention to provide a roller coating method, which does not have the defects with the conventional compositions as described above and, to be specific, to provide a roller coating method that scarcely causes uneven coating.

Other objects, features and advantages of the present invention will become apparent from the detailed descriptions of the preferred embodiments of the invention to follow.

As a result of intensive investigations, the inventor has found that the above-described objects can be attained by using a solvent mixture in a radiation sensitive composition comprising a novolak resin and a quinonediazide photosensitizer for roller coating the composition on a substrate, wherein the solvent is a mixture of from 5 to 20 % by weight, relative to the whole solvent, of propylene glycol and/or dipropylene glycol, and at least one other solvent selected from the group consisting of an alcohol, ethylene glycol monoalkyl ether, ethylene glycol monoalkylether acetate, diethylene glycol monoalkylether, diethyleneglycol monophenylether, diethyleneglycol dialkylether, propylene glycol monoalkylether, propylene glycol monoalkylether acetate, glycol diester, an ester, an aromatic hydrocarbon, an amide, a ketone, dioxane, and tetrahydrofurane.

### Detailed Description of the Preferred Embodiments of the Invention

In the present invention, propylene glycol or dipropylene glycol is used as one component of a mixed solvent for the radiation sensitive composition. One of the reasons that unevenness upon roller coating is improved by using such solvent can be considered as follows, but not wholly clear. That is, the viscosity of propylene glycol and dipropylene glycol is much higher than the other resist solvent ( at 25°C the viscosity of propylene glycol is 43.22 mPa.s (cps), and the viscosity of dipropylene glycol is 77.80 mPa.s (cps). So even if the solid concentration is low, it is possible to provide preferable application viscosity for a resist solution. According to this reason, a large amount of the resist solution is needed for a predetermined resist film thickness after prebaked. Namely, the resist solution, of which the concentration is less than the conventional resist solution, is applied in large quantities, the better self-leveling of the resist solution rises. The above-described reason is merely presumption of inventor, and is not to be construed as limiting the present invention.

Propylene glycol as used in the present invention are highly hygroscopic. In case the coating is conducted under a humidity of between 50 to 60% RH which is an ordinary coating atmosphere, when the concentration of propylene glycol is more than 20% by weight, the resist film after coating and baking tends remarkably to become clouded. When the concentration of propylene glycol is less than 5% by weight, it is difficult to improve the application properties. Therefor the concentration of propylene glycol is from 5 to 20% by weight, preferably from 5 to 15% by weight. If the coating atmosphere is 70% RH, the clouding of resist film take place at a concentration of 10% by weight of propylene glycol. So in case the concentration of propylene glycol is high, it is necessary to adjust the humidity in coating and baking atmosphere to low. On the other hand, dipropylene glycol is not so hygroscopic and no limitation concerned with addition quantity like propylene glycol.

As the solvents to be used in combination with propylene glycol or dipropylene glycol, any solvent that is mentioned in present claim 1 may be used. Representative examples thereof include alcohols such as methanol, ethanol, propanol, butanol, methoxypropanol, ethoxypropanol; ethylene glycol monoalkyl ethers such as ethylene glycol monomethyl ether, ethylene glycol monoethyl ether, ethylene glycol monobutyl ether; ethylene glycol monoalkyl ether acetates such as ethylene glycol monomethyl ether acetate, ethylene glycol monoethyl ether acetate; diethylene glycol monoalkyl ethers such as diethylene glycol monomethyl ether, diethylene glycol monoethyl ether, diethylene glycol monobutyl ether, diethylene glycol monophenyl ether; diethylene glycol dialkyl ethers such as diethylene glycol dimethyl ether, diethylene glycol diethyl ether; propylene glycol monoalkyl ethers such as propylene glycol monomethyl ether, propylene glycol monoethyl ether, propylene glycol monopropyl ether, propylene glycol monobutyl ether; propylene glycol monoalkyl ether acetates such as propylene glycol monomethyl ether acetate, propylene glycol monoethyl ether acetate; glycol diesters such as ethylene glycol diacetate, ethylene glycol dipropionate, propylene glycol diacetate, propylene glycol dipropionate, butanediol diacetate; esters such as ethyl formate, amyl formate, methyl acetate, ethyl acetate, propyl acetate, isopropyl acetate, butyl acetate, isobutyl acetate, amyl acetate, isoamyl acetate, ethyl propionate, butyl propionate, methyl butyrate, ethyl butyrate, butyl butyrate, methyl lactate, ethyl lactate, butyl lactate, 2-ethoxyethyl propionate, 3-ethoxyethyl propionate, 3-methoxybutyl acetate, ethyl acetoacetate: aromatic hydrocarbons such as toluene, xylene; amides such as dimethylformamide, dimethylacetamide, N-methylpyroridone; ketones such as acetone, methyl ethyl ketone, methyl propyl ketone, methyl isopropyl ketone, methyl butyl ketone, methyl isobutyl ketone, methyl pentyl ketone, methyl hexyl ketone, methyl amyl ketone, ethyl propyl ketone, ethyl isopropyl ketone, ethyl butyl ketone, ethyl isobutyl ketone, dibutyl ketone, dipentyl ketone, cyclopentanone, cyclohexanone, methylcyclohexanone, cyclooctanone; dioxane, and tetrahydrofurane. Preferred solvents are propylene glycol monomethyl ether acetate (PGMEA), propylene glycol monomethyl ether (PGME), ethylene glycol monoethyl ether acetate (EGA), propylene glycol t-butyl ether (PtB) and ethyl lactate(EL). These solvents may be used alone or in combination of two or more of them.

Radiation sensitive materials to be used in the present invention comprise an alkali-soluble resin and a quinonediazide compound.

Several examples of the alkali-soluble resin and the quinonediazide compound are illustrated below. That is, as the alkali-soluble resin, there are illustrated novolak resin, polyvinylphenol, polyvinyl alcohol, copolymers of acrylic acid or methacrylic acid, etc. The novolak resin is exemplified by a polycondensation product between one or more of phenols such as phenol, o-cresol, m-cresol, p-cresol, xylenol, trimethylphenol, t-butylphenol, ethylphenol, 2-naphthol or 1,3-dihydroxynaphthalene and an aldehyde such as formaldehyde or para-formaldehyde. These alkali-soluble resins such as the novolak resin may be used in combination of two or more, if necessary.

Examples of the quinonediazide compound include 1,2-benzoquinonediazide-4-sulfonic acid, 1,2-naphthoquinonediazide-4-sulfonic acid, 1,2-naphthoquinonediazide-5-sulfonic acid, esters or amides of these sulfonic acids, etc. The sulfonic acid esters or amides of the quinonediazides can be obtained by the condensation reaction between a corresponding quinonediazide sulfonic acid or quinonediazidesulfonyl chloride and a hydroxyl group-having compound or an amino group-having compound. As the hydroxyl group-containing compound, there are illustrated dihydroxybenzophenone, trihydroxybenzophenone, tetrahydroxybenzophenone, pentahydroxybenzophenone, phenol, naphthol, p-methoxyphenol, bisphenol A, pyrocatechol, pyrogallol, pyrogallol methyl ether, gallic acid, α, α ', α "-tris(4-hydroxyphenyl)-1,3,5-triisopropylbenzene, tris (hydroxyphenyl)methane, etc. and, as the amino group-having compound, there are illustrated aniline, p-aminodiphenylamine, etc. These quinonediazide sensitizers may be used alone or as a mixture of two or more of them. In addition, as the quinonediazidesulfonic acid esters, esters between a polycondensation product of a phenol and an aldehyde or ketone and the quinonediazidesulfonic acid may also be used.

The ratio of the above-described quinonediazide compound to the alkali-soluble resin to be used varies depending upon the kinds of actually used quinonediazide compound and alkali-soluble resin but, in general, it is in the range of from 1:1 to 1:20, though the present invention not being limited thereto.

Further, known or well known various components such as sensitizers, surfactants, etc. may optionally be added to the radiation sensitive composition.

The amount of a mixed solvent as containing from 5 to 20 % by weight of at least one selected from propylene glycol and dipropylene glycol to the resist varies depending upon the kind of resist used and the kinds of solvents but, usually, it ranges from 50 to 3,000 parts by weight, preferably from 70 to 2,000 parts by weight, more preferably from 100 to 1,000 parts by weight, per 100 parts by weight of resist solid components.

The radiation sensitive composition for roller coating is prepared by dissolving a radiation sensitive material, and if necessary optional various components in the aforementioned solvent and, if necessary, filtering the resulting solution. The thus prepared composition is coated on a substrate such as a liquid crystal display substrate using a roller coater in a prebaked thickness of usually 1.0 to 2.5 *µ*m. The composition coated on the substrate is then prebaked, for example, on a hot plate to remove the solvent and form a radiation sensitive resist layer. Prebaking temperature varies depending upon the kind of solvent or radiation sensitive material used but, usually, prebaking is conducted at between about 30 to about 200°C, preferably about 50 to 150°C.

After formation of the resist layer, exposure is conducted. The exposure is conducted using a known exposing apparatus such as a high pressure mercury lamp, a metal halide lamp, a super-high pressure mercury lamp, a KrF excimer laser, a soft X-ray beam generator, an electron beam writer, or the like optionally through a mask. After the pattern-wise exposure, the exposed resist layer is optionally subjected to post exposure baking for improving developability, resolving power, pattern profile, etc., and is developed. After the development, dry etching may optionally be conducted by using, for example, gas plasma for removing an anti-reflective coating or the like to create a resist pattern.

Development of the above-described resist is usually conducted by using a developer solution utilizing difference in solubility for a solvent or an alkali solution between exposed areas and unexposed areas. As an alkaline developer solution, a water solution or an aqueous solution of an inorganic alkali (e. g. , sodium hydroxide, potassium hydroxide, sodium carbonate, sodium silicate), an amine (e.g., ammonia, ethylamine, diethylamine, triethylamine, diethylethanolamine, triethanolamine, benzylamine), an amide (e. g. , formamide), a quaternary ammonium salt (e.g., tetramethylammonium hydroxide (TMAH), tetraethylammonium hydroxide, choline), a cyclic amine (e.g., pyrrole, piperadine) is used.

The present invention is now described in more detail by reference to Examples and Comparative Examples which, however, are not construed to be limitative at all.

### Examples 1 to 5 and Comparative Example 1

A polycondensation product (novolak resin) between m-cresol/p-cresol (6/4) and formaldehyde and a condensation product (quinonediazide photosensitizer) between 2,3,4-trihydroxybenzophenone and 1,2-naphthoquinonediazide-5-sulfonyl chloride were used, as a radiation sensitive material, in a proportion of 100:20 by weight and, after dissolving the material in various solvents shown in Table 1 to prepare solutions of 30 mPa·s (cps) in viscosity. Each solution was coated on a Cr-layered glass substrate (300 x 360 x 1.1 mm) in a prebaked thickness of 1.5 *µ* m using a roller coater, RC-353-P, made by Dainippon Screen Seizou Kabushiki Kaisha. After coating, the substrates were subjected to prebaking (proximity: 100 seconds; direct: 100 seconds) on a direct hot plate at 100°C. Viewing of the thus prebaked substrates under a sodium lamp (yellow lamp) gave the results shown in Table 1. Additionally, coating properties and drying properties in Table 2 were evaluated according to the following evaluation criteria.

### Coating properties:

A: No unevenness in coating thickness was observed, and no difference in brightness was observed when viewed as a liquid crystal display element under the yellow lamp.
B: Unevenness in coating thickness was scarcely observed, and no difference in brightness was observed when viewed as a liquid crystal display element under the yellow lamp.
C: Unevenness in coating thickness was observed, and difference in brightness was visually detected when viewed as a liquid crystal display element under the yellow lamp.
D: Unevenness and roughness in coating thickness was observed, and difference in brightness was clearly detected when viewed as a liquid crystal display element under the yellow lamp.

### Drying properties:

A: Drying was completed within a time 1.2 times as much as the standard time required for drying a coating containing PGMEA as a solvent.
B: Drying was completed within a time 1.5 times as much as the standard time required for drying a coating containing PGMEA as a solvent.
C: Drying was completed within a time 2 times as much as the standard time required for drying a coating containing PGMEA as a solvent.
D: Drying was completed only after a time 2 times as much as the standard time required for drying a coating containing PGMEA as a solvent.

Additionally, % in the following tables means % by weight.

**Table 1**

| | main solvent | additive solvent | Coating Properties | Drying Properties |
|---|---|---|---|---|
| Example 1 | PGMEA 80% | PG 20% | A | C |
| Example 2 | PGMEA 83% | PG 17% | B | B |
| Example 3 | PGMEA 85% | PG 15% | B | B |
| Example 4 | PGMEA 87% | PG 13% | B | B |
| Example 5 | PGMEA 90% | PG 10% | B | B |
| Comparative Example 1 | PGMEA 100% | PG 0% | D | A |

It can be seen from Table 1 that coating properties can be improved markedly by adding propylene glycol(PG) into propylene glycol monomethyl ether acetate (PGMEA). The coating property becomes better as the content of PG is increased, but drying property drops slightly down. In addition, in case the contents of PG are beyond 20 % by weight, the coating layer becomes markedly clouded, so it is not practical.

### Examples 6 to 8 and Comparative Example 2

The same procedures as in Example 1 were conducted except for using as the solvent those shown in Table 2. Thus, there were obtained the results shown in Table 2.

**Table 2**

| | main solvent | additive solvent | Coating Properties | Drying Properties |
|---|---|---|---|---|
| Example 6 | EGA 83% | PG 17% | B | C |
| Example 7 | EGA 85% | PG 15% | B | C |
| Example 8 | EGA 87% | PG 13% | B | B |
| Comparative Example 2 | EGA 100% | PG 0% | D | B |

It is seen from Table 2 that coating properties can be increasingly improved by addition of propylene glycol (PG) to ethylene glycol monomethyl ether acetate (EGA). The coating property becomes better as the content of PG is increased, but drying property drops slightly down.

### Examples 9 to 11

The same procedures as in Example 1 were conducted except for using as the solvent those shown in Table 3. Thus, there were obtained the results shown in Table 3.

**Table 3**

| | main solvent | additive solvent | Coating Properties | Drying Properties |
|---|---|---|---|---|
| Example 9 | PGMEA 80% | DPG 20% | B | B |
| Example 10 | PGMEA 85% | DPG 15% | B | B |
| Example 11 | PGMEA 90% | DPG 10% | B | B |

It is seen from Table 3 that coating properties can be increasingly improved by addition of dipropylene glycol (DPG) into propylene glycol monomethyl ether acetate (PGMEA).

### Examples 12 to 16

The same procedures as in Example 1 were conducted except for using as the solvent those shown in Table 4. Thus, there were obtained the results shown in Table 4.

**Table 4**

| | main solvent | | additive solvent | Drying Properties | Coating Properties |
|---|---|---|---|---|---|
| Example 15 | EGA 50% | PtB 40% | PG 10% | B | B |
| Example 16 | EGA 47.5% | PtB 40% | PG 12.5% | A | C |
| Example 17 | EGA 50% | EL 40% | PG 10% | A | B |
| Example 15 | EGA 47.5% | EL 40% | PG 12.5% | A | C |
| Example 16 | EGA 30% | EL 62.5% | PG 7.5% | A | B |

Coating property can also be improved by using mixed solvent as main solvent. It is seen from Table 4 that excellent coating properties and good drying properties can be obtained by using mixed solvents as comprising ethylene glycol monoethyl acetate (EGA) and propylene glycol t-butyl ether (PtB) or ethylene glycol monoethyl acetate (EGA) and ethyl lactate(EL).

Additionally, though drying properties generally tend to be deteriorated with the improvement of coating properties as is seen from the above results, it does not spoil industrial utility. For example, in using these radiation sensitive compositions for manufacturing liquid crystal display elements, difference in brightness is decreased owing to improved coating properties in spite of slight deterioration of drying properties, thus products with extremely high quality being obtained. Therefore, in actual manufacturing, it suffices to select solvent formulation taking the balance between coating properties and drying properties into consideration.

As has been described hereinbefore, the present invention provides a remarkable advantage that a coating layer can be formed with no coating unevenness by coating a radiation sensitive composition on a substrate; said composition containing 20 % by weight or less of propylene glycol and/or dipropylene glycol as one component of mixed solvent.

In addition, since no coating unevenness takes place when the radiation sensitive composition of the present invention is used, there is provided another marked advantage that liquid crystal element displays with high quality which do not present uneven brightness can be manufactured using a roller coater.

## Claims

1. The use of a solvent mixture in a radiation sensitive composition comprising a novolak resin and a quinonediazide photosensitizer for coating the composition on a substrate by roller coating, wherein the solvent is a mixture of from 5 to 20 % by weight, relative to the whole solvent, of propylene glycol and/or dipropylene glycol,
and at least one other solvent selected from ether group consisting of an alcohol, ethylene glycol monoalkylether, ethylene glycol monoalkylether acetate, diethylene glycol monoalkylether, diethyleneglycol monophenylether, diethyleneglycol dialkylether, propylene glycol monoalkylether, propylene glycol monoalkylether acetate, glycol diester, an ester, an aromatic hydrocarbon, an amide, a ketone, dioxane, and tetrahydrofurane.

2. The use as claimed in claim 1, wherein the other solvent is methanol, ethanol, propanol, butanol, methoxypropanol, ethoxypropanol, ethylene glycol monomethylether, ethylene glycol monoethylether, ethylene glycol monobutylether, ethylene glycol monomethyl ether acetate, ethylene glycol monoethyl ether acetate, diethylene glycol monomethylether, diethylene glycol monoethylether, diethylene glycol monobutylether, diethyleneglycol dimethylether, diethylene glycol diethylether, propylene glycol monomethyl ether, propylene glycol monoethyl ether, propylene glycol monopropyl ether, propylene glycol monobutyl ether, propylene glycol monomethyl ether acetate, propylene glycol monoethyl ether acetate, ethylene glycol diacetate, ethylene glycol dipropionate, propylene glycol diacetate, propylene glycol dipropionate, butanediol diacetate, ethyl formate, amyl formate, methyl acetate, ethyl acetate, propyl acetate, isopropyl acetate, butyl acetate, isobutyl acetate, amyl acetate, isoamyl acetate, ethyl propionate, butyl propionate, methyl butyrate, ethyl butyrate, butyl butyrate, methyl lactate, ethyl lactate, butyl lactate, 2-ethoxyethyl propionate, 3-ethoxyethyl propionate, 3-methoxybutyl acetate, ethyl acetoacetate, toluene, xylene, dimethylformamide, dimethylacetamide, N-methylpyrrolidone, acetone, methyl ethyl ketone, methyl propyl ketone, methyl isopropyl ketone, methyl butyl ketone, methyl isobutyl ketone, methyl pentyl ketone, methyl hexyl ketone, methyl amyl ketone, ethyl propyl ketone, ethyl isopropyl ketone, ethyl butyl ketone, ethyl isobutyl ketone, dibutyl ketone, dipentyl ketone, cyclopentanone, cyclohexanone, methylcyclohexanone, cyclooctanone or a combination thereof.

3. The use as claimed in claim 1 or 2, wherein the other solvent is propylene glycol monomethyl ether acetate, propylene glycol monomethyl ether, ethylene glycol monoethyl ether acetate, propylene glycol t-butyl ether, ethyl lactate, or a combination thereof.

4. The use as claimed in any of claims 1 to 3, wherein the proportion of propylene glycol and/or dipropylene glycol is from 5 to 15 % by weight.

5. The use as claimed in claim 1, wherein the novolak resin is a polycondensation product between phenol, o-cresol, m-cresol, p-cresol, xylenol, trimethylphenol, t-butylphenol, ethylphenol, 2-naphthol, or 1,3-dihydroxynaphthalene and formaldehyde or para-formaldehyde.

6. The use as claimed in any of claims 1 to 5, wherein the amount of the solvent mixture ranges from 50 to 3,000 parts by weight per 100 parts by weight of resist solid components.

7. The use as claimed in any mixture claims 1 to 6, comprising the use of a roller coater a prebaked and/coating and thickness of 1.0 to 2.5 µm.

8. The use of claim 1, wherein the substrate is a liquid crystal display substrate.

## Patentansprüche

1. Verwendung eines Lösungsmittelgemisches in einer strahlungsempfindlichen Zubereitung, bestehend aus einem Novolakharz und einem Chinondiazid-Photosensibilisator, zum Aufbringen der Zubereitung auf einen Träger mittels Walzen auftrag, wobei das Lösungsmittel ein Gemisch aus 5 bis 20 Gewichtsprozent Propylenglycol und/oder Dipropylenglycol, bezogen auf das gesamte Lösungsmittel, und aus mindestens einem anderen Lösungsmittel ist, das aus einer Gruppe ausgewählt wird, die aus einem Alkohol, Ethylenglycolmonoalkylether, Ethylenglycolmonoalkyletheracetat, Diethylenglycolmonoalkylether, Diethylenglycolmonophenylether, Diethylenglycoldialkylether, Propylenglycolmonoalkylether, Propylenglycolmonoalkyletheracetat, Glycoldiester, einem Ester, einem aromatischen Kohlenwasserstoff, einem Amid, einem Keton, Dioxan und Tetrahydrofuran besteht.

2. Verwendung gemäß Anspruch 1, wobei das andere Lösungsmittel Methanol, Ethanol, Propanol, Butanol, Methoxypropanol, Ethoxypropanol, Ethylenglycolmonomethylether, Ethylenglycolmonoethylether, Ethylenglycolmonobutylether, Ethylenglycolmonomethyletheracetat, Ethylenglycolmonoethyletheracetat, Diethylenglycolmonomethylether, Diethylenglycolmonoethylether, Diethylenglycolmonobutylether, Diethylenglycoldimethylether, Diethylenglycoldiethylether, Propylenglycolmonomethylether, Propylenglycolmonoethylether, Propylenglycolmonopropylether, Propylenglycolmonobutylether, Propylenglycolmonomethyletheracetat, Propylenglycolmonoethyletheracetat, Ethylenglycoldiacetat, Ethylenglycoldipropionat, Propylenglycoldiacetat, Propylenglycoldipropionat, Butandioldiacetat, Ethylformiat, Amylformiat, Methylacetat, Ethylacetat, Propylacetat, Isopropylacetat, Butylacetat, Isobutylacetat, Amylacetat, Isoamylacetat, Ethylpropionat, Butylpropionat, Methylbutyrat, Ethylbutyrat, Butylbutyrat, Methyllactat, Ethyllactat, Butyllactat, 2-Ethoxyethylpropionat, 3-Ethoxyethylpropionat, 3-Methoxybutylacetat, Acetessigester, Toluol, Xylol, Dimethylformamid, Dimethylacetamid, N-Methylpyrrolidon, Aceton, Methylethylketon, Methylpropylketon, Methylisopropylketon, Methylbutylketon, Methylisobutylketon, Methylpentylketon, Methylhexylketon, Methylamylketon, Ethylpropylketon, Ethylisopropylketon, Ethylbutylketon, Ethylisobutylketon, Dibutylketon, Dipentylketon, Cyclopentanon, Cyclohexanon, Methylcyclohexanon, Cyclooctanon oder eine Kombination dieser Substanzen ist.

3. Verwendung gemäß Anspruch 1 oder 2, wobei das andere Lösungsmittel Propylenglycolmonomethyletheracetat, Propylenglycolmonomethylether, Ethylenglycolmonoethyletheracetat, Propylenglycol-t-butylether, Ethyllactat oder eine Kombination dieser Substanzen ist.

4. Verwendung gemäß einem der Ansprüche 1 bis 3, wobei der Anteil von Propylenglycol und/oder Dipropylenglycol 5 bis 15 Gewichtsprozent beträgt.

5. Verwendung gemäß Anspruch 1, wobei das Novolakharz ein Polykondensationsprodukt zwischen Phenol, o-Kresol, m-Kresol, p-Kresol, Xylenol, Trimethylphenol, t-Butylphenol, Ethylphenol, 2-Napththol oder 1,3-Dihydroxynaphthalin und Formaldehyd oder Paraformaldehyd ist.

6. Verwendung gemäß einem der Ansprüche 1 bis 5, wobei die Menge des Lösungsmittelgemisches im Bereich von 50 bis 3000 Gewichtsteilen pro 100 Gewichtsteile Feststoffgehalt des Resists liegt.

7. Verwendung gemäß einem der Ansprüche 1 bis 6, einschließlich der Verwendung einer Auftragwalze und einer Schichtdicke von 1,0 bis 2,5 µm vor dem Trocknen.

8. Verwendung gemäß Anspruch 1, wobei der Träger ein Flüssigkristallanzeigen-Träger ist.

## Revendications

1. Utilisation d'un mélange de solvants dans une composition sensible au rayonnement comprenant une résine novolaque et un photosensibilisateur constitué d'un diazide de quinone pour appliquer la composition sur un substrat par couchage au rouleau, dans laquelle le solvant est un mélange comprenant de 5 à 20 % en poids, par rapport à la totalité du solvant, de propylène glycol et/ou de dipropylène glycol, et au moins un autre solvant choisi dans le groupe constitué par un alcool, un monoalkyléther d'éthylène glycol, un acétate de monoalkyléther d'éthylène glycol, un monoalkyléther de diéthylène glycol, un monophényléther de diéthylène glycol, un dialkyléther de diéthylène glycol, un monoalkyléther de propylène glycol, un acétate de monoalkyléther de propylène glycol, un diester de glycol, un ester, un hydrocarbure aromatique, un amide, une cétone, le dioxane, et le tétrahydrofuranne.

2. Utilisation selon la revendication 1, dans laquelle l'autre solvant est le méthanol, l'éthanol, le propanol, le butanol, le méthoxypropanol, l'éthoxypropanol, le monométhyléther d'éthylène glycol, le monoéthyléther d'éthylène glycol, le monobutyléther d'éthylène glycol, l'acétate de monométhyléther d'éthylène glycol, l'acétate de monoéthyléther d'éthylène glycol, le monométhyléther de diéthylène glycol, le monoéthyléther de diéthylène glycol, le monobutyléther de diéthylène glycol, le diméthyléther de diéthylène glycol, le diéthyléther de diéthylène glycol, le monométhyléther de propylène glycol, le monoéthyléther de propylène glycol, le monopropyléther de propylène glycol, le monobutyléther de propylène glycol, l'acétate de monométhyléther de propylène glycol, l'acétate de monoéthyléther de propylène glycol, le diacétate d'éthylène glycol, le dipropionate d'éthylène glycol, le diacétate de propylène glycol, le dipropionate de propylène glycol, le diacétate de butanediol, le formate d'éthyle, le formate d'amyle, l'acétate de méthyle, l'acétate d'éthyle, l'acétate de propyle, l'acétate d'isopropyle, l'acétate de butyle, l'acétate d'isobutyle, l'acétate d'amyle, l'acétate d'isoamyle, le propionate d'éthyle, le propionate de butyle, le butyrate de méthyle, le butyrate d'éthyle, le butyrate de butyle, le lactate de méthyle, le lactate d'éthyle, le lactate de butyle, le propionate de 2-éthoxyéthyle, le propionate de 3-éthoxyéthyle, l'acétate de 3-méthoxybutyle, l'acétoacétate d'éthyle, le toluène, le xylène, le diméthylformamide, le diméthylacétamide, la N-méthylpyrrolidone, l'acétone, la méthyléthylcétone, la méthylpropylcétone, la méthylisopropylcétone, la méthylbutylcétone, la méthylisobutylcétone, la méthylpentylcétone, la méthylhexylcétone, la méthylamylcétone, l'éthylpropylcétone, l'éthylisopropylcétone, l'éthylbutylcétone, l'éthylisobutylcétone, la dibutylcétone, la dipentylcétone, la cyclopentanone, la cyclohexanone, la méthylcyclohexanone, la cyclooctanone ou une combinaison de ceux-ci.

3. Utilisation selon la revendication 1 ou 2, dans laquelle l'autre solvant est l'acétate de monométhyléther de propylène glycol, le monométhyléther de propylène glycol, l'acétate de monoéthyléther d'éthylène glycol, le t-butyléther de propylène glycol, le lactate d'éthyle, ou une combinaison de ceux-ci.

4. Utilisation selon l'une quelconque des revendications 1 à 3, dans laquelle la proportion de propylène glycol et/ou de dipropylène glycol varie de 5 à 15 % en poids.

5. Utilisation selon la revendication 1, dans laquelle la résine novolaque est un produit de polycondensation entre le phénol, l'o-crésol, le m-crésol, le p-crésol, le xylénol, le triméthylphénol, le t-butylphénol, l'éthylphénol, le 2-naphthol, ou le 1,3-dihydroxynaphtalène et le formaldéhyde ou le paraformaldéhyde.

6. Utilisation selon l'une quelconque des revendications 1 à 5, dans laquelle la quantité du mélange de solvants varie de 50 à 3 000 parties en poids par 100 parties en poids des composants solides de réserve.

7. Utilisation selon l'une quelconque des revendications 1 à 6, comprenant l'utilisation d'une machine à enduction par laminage et d'une épaisseur de revêtement précuit de 1,0 à 2,5 µm.

8. Utilisation selon la revendication 1, dans laquelle le substrat est un substrat à affichage à cristaux liquides.
